# FASCICULE DE BREVET EUROPEEN

(11) **EP 1 052 885 B1**
(45) Date de publication et mention de la délivrance du brevet: **03.09.2008**
(21) Numéro de dépôt: 00401035.1
(22) Date de dépôt: 13.04.2000
(51) Int. Cl.: H05K 7/20

(54) **Caisson pour contenir un équipement électronique refroidi par ventilation**
Luftgekühltes Gehäuse für elektronische Geräte
Air cooled enclosure for electronic equipment

(30) Priorité: 20.04.1999 FR 9904976
(43) Date de publication de la demande: 15.11.2000
(73) Titulaire: BULL S.A., 78430 Louveciennes (FR)
(72) Inventeur: Ducourt, Emmanuel, 78130 Les Mureaux (FR); Prevot, Jean-Paul, 78330 Fontenay le Fleury (FR)

(56) Documents cités:
- US-A- 5 793 610
- "MODULAR DISK ASSEMBLY" IBM TECHNICAL DISCLOSURE BULLETIN,US,IBM CORP. NEW YORK, vol. 38, no. 8, page 35-36 XP000534419 ISSN: 0018-8689
- "FAULT-TOLERANT COOLING OF MULTIPLE PARALLEL PROCESSOR MODULES" IBM TECHNICAL DISCLOSURE BULLETIN,US,IBM CORP. NEW YORK, vol. 39, no. 5, page 171-172 XP000584095 ISSN: 0018-8689

## Description

Le domaine de l'invention est celui du refroidissement d'équipements électroniques par ventilation. L'invention concerne plus particulièrement un caisson pour contenir un équipement électronique nécessitant d'être refroidi.

Selon l'état de la technique connu, un tel caisson contient deux ouvertures avec un ventilateur proche d'une première ouverture, aspirant l'air contenu dans le caisson pour le propulser à l'extérieur par la première ouverture. La dépression qui en résulte dans le caisson, crée un appel d'air par la deuxième ouverture qui, en circulant le long de l'équipement électronique, le refroidit.

Pour éviter de devoir arrêter l'équipement électronique lorsque le ventilateur est en panne, le caisson est équipé de plusieurs ventilateurs. Ainsi, lorsqu'un ventilateur est en panne, le refroidissement continue à être assuré par un ou plusieurs autres ventilateurs fonctionnant en secours.

Pour remplacer le ventilateur en panne, celui-ci est extrait du caisson par une ouverture spécialement prévue à cet effet. Un autre ventilateur est ensuite introduit dans le caisson par cette même ouverture.

En absence d'un ventilateur dans le caisson, l'ouverture d'introduction extraction, crée un appel d'air dans le caisson vers l'autre ventilateur qui, en réduisant la dépression dans le caisson, est préjudiciable au bon refroidissement de l'équipement électronique et éventuellement au régime de fonctionnement du ventilateur de secours.

Il est bien entendu possible de mettre un couvercle sur l'ouverture d'introduction extraction en attendant de mettre un autre ventilateur. Cependant le problème de l'appel d'air entre le moment où le ventilateur est extrait et le moment où le ventilateur est extrait et le moment où le couvercle est mis, puis entre le moment où le couvercle est enlevé et le moment où l'autre ventilateur est introduit reste posé.

Il est connu du document intitulé « Modular Disk Assembly », IBM Technical Disclosure Bulletin, US, Volume 38, numéro 8, pages 35 et 36 publié en août 1995, une structure modulaire pour accueillir des composants d'ordinateur avant une ouverture dans laquelle est positionné un ventilateur. Un rabat est présent dans cette ouverture et est maintenu par un ressort de sorte à fermer l'ouverture lorsque le ventilateur est absent. Lors de l'insertion d'un ventilateur, le rabat pivote de sorte à permettre au ventilateur de glisser dans l'ouverture.

L'invention a pour objet un caisson comprenant au moins un équipement électronique et une ouverture pour extraire un premier ventilateur. Le caisson comprend un élément mobile qui
- lorsque le ventilateur est dans le caisson, est maintenu en contact avec au moins une face du ventilateur et,
- lorsque le ventilateur n'est pas dans le caisson, est maintenu en contact avec le caisson, de façon à obstruer l'ouverture du caisson.

Ainsi, dès que le ventilateur a quitté le caisson, la plaque obstrue immédiatement l'ouverture d'introduction sans manipulation extérieure supplémentaire. Aucune discontinuité dans le refroidissement de l'équipement électronique n'est observée.

Il est possible d'utiliser comme élément mobile, une plaque maintenue en position d'obstruction de l'ouverture par exemple au moyen d'un ressort. En faisant ripper ladite plaque, il est possible de dégager l'ouverture de façon à permettre l'extraction du ventilateur, ladite plaque étant maintenue contre le ventilateur pendant l'extraction par augmentation de contrainte du ressort. De cette manière, la plaque vient directement refermer l'ouverture dès que le ventilateur a totalement quitté le caisson.

Cependant, le dispositif mentionné au paragraphe précédent nécessite une manipulation préalable à l'extraction du ventilateur, à savoir celle de faire ripper la plaque. Un avantage supplémentaire est procuré par l'invention lorsque ledit élément mobile est maintenu par la présence du ventilateur dans le caisson à une position laissant l'ouverture libre pour extraire le ventilateur, ce qui évite la manipulation préalable.

Une mise en oeuvre particulière de l'invention est expliquée dans la description qui suit en référence aux figures où:
- les figures 1a, 1b, 1c présentent un caisson dépourvu des caractéristiques de l'invention,
- les figures 2a, 2b, 2c présentent un premier exemple de caisson conforme à l'invention,
- les figures 3a, 3b, 3c présentent un deuxième exemple de caisson conforme à l'invention,
- les figures 4a, 4b, 4c présentent un troisième exemple de caisson conforme à l'invention,
- les figures 5a, 5b, 5c présentent un quatrième exemple de caisson conforme à l'invention,

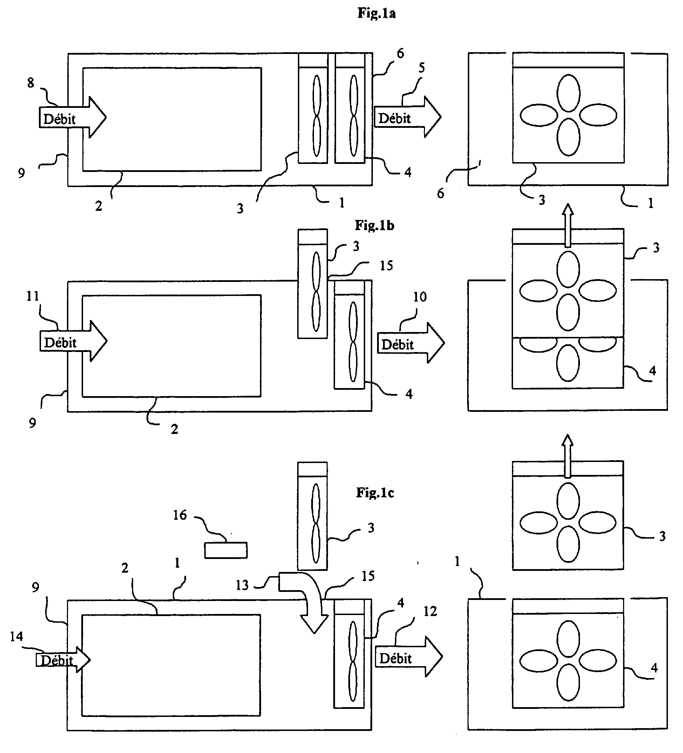

En référence à la figure 1a, un caisson **1** comprend un équipement électronique **2** et deux ventilateurs **3, 4**. Les ventilateurs **3, 4** sont prévus pour propulser un débit d'air **5** à travers une première ouverture sur une face **6** du caisson. Le débit d'air **5** est aspiré de l'intérieur du caisson **1** vers l'extérieur. La dépression ainsi provoquée dans le caisson **1**, fait entrer un débit d'air **8** par une deuxième ouverture sur une face **9** opposée à la face **6**. Le caisson **1** est suffisamment étanche pour que le débit **8** soit égal au débit **5**.

Ce dispositif assure une circulation d'air dans le caisson **1** de la face **9** à la face 6, le long de l'équipement électronique **2**. Cette circulation d'air permet de refroidir l'équipement électronique **2**. La face **9** n'est pas nécessairement la face opposée à la face **6**. Dans le cas où la face **9** est une face latérale du caisson **1**, la deuxième ouverture est disposée de façon à assurer une circulation d'air suffisante le long de l'équipement électronique **2**, selon l'état de la technique connu. L'enseignement décrit ici pour des ventilateurs qui aspirent l'air du caisson **1**, reste valable pour des ventilateurs qui aspirent de l'air extérieur de façon à le comprimer à l'intérieur du caisson. Dans ce cas, la surpression ainsi créée à l'intérieur du caisson **1**, propulse l'air vers l'extérieur par la deuxième ouverture sur la face **9**. La solution de la surpression augmente la turbulence de la circulation d'air dans le caisson **1**. Une turbulence élevée favorise les échanges de chaleur mais une compression augmente la température de l'air circulant. L'homme du métier choisit la solution qui convient le mieux en calculant les coefficients d'échange optimaux.

Lorsqu'un ventilateur tombe en panne, par exemple le ventilateur **3**, le débit **5**, **8**, est affaibli. Comme représenté sur la figure 1b, le ventilateur **3** est retiré par une ouverture **15**, de façon à pouvoir le remplacer. Le ventilateur **4** tourne en mode secours de façon à extraire un débit d'air **10** du caisson **1**, de préférence équivalent au débit **5** . Pendant l'extraction du ventilateur **3**, l'ouverture **15** reste pratiquement obstruée par le ventilateur et le débit **10** est sensiblement égal à un débit **11** entrant par la face **9**. Tant que le ventilateur **3** n'est pas totalement retiré, le ventilateur **4** continue à refroidir l'équipement électronique **2**.

Lorsque le ventilateur **3** est totalement retiré comme représenté sur la figure 1c, l'ouverture **15** laisse entrer un débit d'air **13** dans le caisson en dépression. Le débit **13** a pour effet d'amoindrir considérablement le débit entrant par la face **9**, ne laissant subsister qu'un débit faible **14** dont la circulation le long de l'équipement électronique **2** n'en assure plus un refroidissement optimal. Le débit **12** aspiré par le ventilateur **4** est égal à la somme des débits **13** et **14**. Après extraction du ventilateur **3**, il est possible d'obstruer l'ouverture **15** par une plaque **16** ou par un nouveau ventilateur **3**. Cependant, l'intervalle de temps qui sépare la fin de l'extraction du ventilateur **3** de la mise en place de la plaque **16** ou du nouveau ventilateur, est préjudiciable au bon refroidissement de l'équipement électronique **2**.

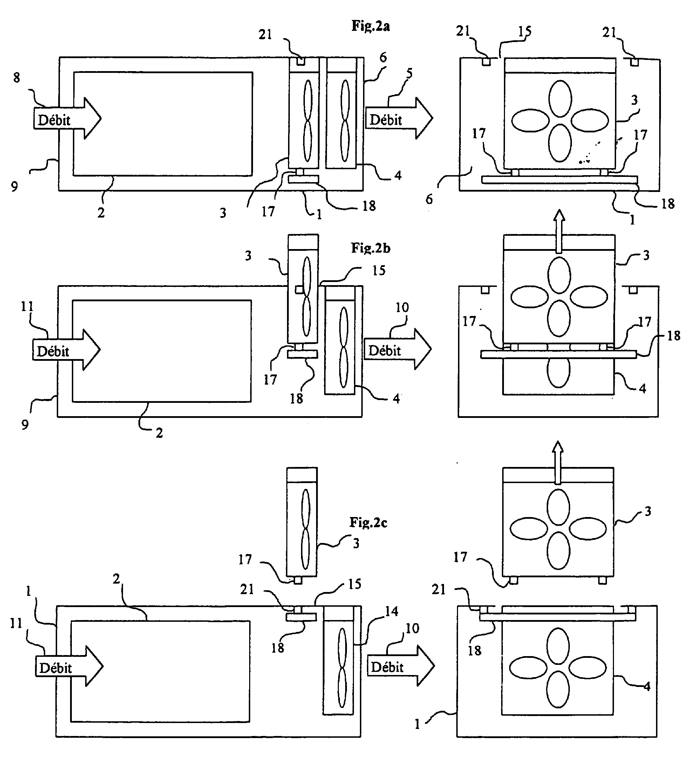

En référence aux figures 2a à 2c, des aimants **17** sont fixés sur la face du ventilateur **3**, opposée à l'ouverture **15**. Des aimants **21** sont fixés sur une face intérieure du caisson **1** sur le pourtour de l'ouverture **15**.

En référence à la figure 2a, les aimants **17** retiennent magnétiquement une plaque **18** dont l'aire est supérieure à l'aire de l'ouverture **15**. Le refroidissement par le dispositif de la figure 2a est identique à celui procuré par le dispositif de la figure **1**a.

En référence à la figure 2b, l'extraction du ventilateur **3** par l'ouverture **15**, entraîne la plaque **18** maintenue en contact avec la face du ventilateur **3** sur laquelle sont fixés les aimants **17**. Cette face étant celle la plus éloignée de l'ouverture **15** pour la partie du ventilateur **3** encore dans le caisson **1**, la plaque est rapprochée de l'ouverture **15** pendant l'extraction du ventilateur **3**. Tant que la face sur laquelle sont fixés les aimants **17** est dans le caisson **1**, le ventilateur **3** obstrue l'ouverture **15**. Le refroidissement de l'équipement électronique **2** est identique à celui qui résulte de la figure 1b.

En référence à la figure 2c, lorsque la face du ventilateur **3** sur laquelle sont fixés les aimants **17**, quitte le caisson **1**, la plaque **18** dont l'aire est supérieure à celle de l'ouverture **15**, est retenue par le caisson **1** au niveau de cette ouverture. La plaque **18** est alors maintenue en contact avec le caisson **1** par les aimants **21** qui y sont fixés. Ainsi, la plaque **18** obstrue l'ouverture **15** dès que le ventilateur **3** a quitté le caisson **1**. Le débit d'air sortant **10** est égal au débit d'air entrant **11** en absence du ventilateur **3** dans le caisson **1** à tout moment.

Une introduction du ventilateur **3** dans le caisson **1** est effectué par processus inverse en remontant des figures 2c à 2a. La plaque **18** est alors initialement maintenue en contact avec le caisson par les aimants **21** comme représenté en figure 2c. L'introduction du ventilateur **3** vient pousser la plaque **18** qui se désolidarise des aimants **21**, comme représenté en figure 2b. La plaque **18** est maintenue en contact avec le ventilateur **3** au moyen des aimants **17**. L'introduction du ventilateur **3** obstrue l'ouverture **15** de sorte que la valeur des débits **10** et **11** reste sensiblement constante. Le ventilateur **3** étant entièrement introduit dans le caisson **1** comme représenté en figure 2a, la plaque 18 est maintenue en contact avec le ventilateur **3**.

Grâce au dispositif représenté figures 2a à 2c, le bon refroidissement de l'équipement électronique **2** ne subit aucune interruption lors d'extraction ou d'introduction du ventilateur **3** par l'ouverture **15** dans le caisson **1**.

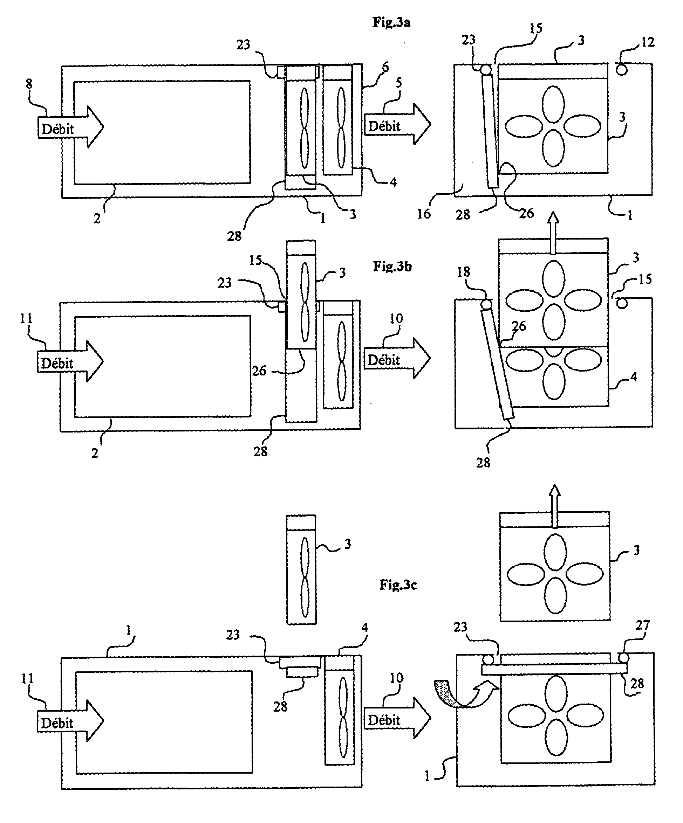

En référence aux figures 3a à 3c, une première extrémité de ressort **23** est fixée sur une face intérieure du caisson **1** sur une arrête de l'ouverture **15**. Une première arrête de plaque **28** est fixée à une deuxième extrémité du ressort **23**. Le ressort **23** est comprimé en rotation.

En référence à la figure 3a, le ventilateur **3** appuie sur la plaque **28** de façon à comprimer au maximum le ressort **23.** La compression du ressort **23** maintient la plaque **28** en contact avec une arrête **26** commune à la face inférieure du ventilateur **3** et à la face verticale du ventilateur **3** la plus proche du ressort **23**. La face inférieure du ventilateur **3** est ici la face la plus éloignée de l'ouverture **15**. Le refroidissement par le dispositif de la figure **3**a est identique à celui procuré par le dispositif de la figure 1a.

En référence à la figure 3b, pendant l'extraction du ventilateur **3** par l'ouverture **15**, la plaque **28** est maintenue en contact avec l'arrête **26** de la face inférieure du ventilateur **3** par la compression du ressort **23**. Cette face étant celle la plus éloignée de l'ouverture **15** pour la partie du ventilateur **3** encore dans le caisson **1**, l'extraction du ventilateur **3** décomprime le ressort **23** qui a pour effet de mettre en rotation la plaque **28** pour la rapprocher de l'ouverture **15**. Tant que la face inférieure est dans le caisson **1**, le ventilateur **3** obstrue l'ouverture **15**. Le refroidissement de l'équipement électronique **2** est identique à celui qui résulte de la figure 1b.

En référence à la figure 3c, lorsque la face inférieure du ventilateur **3** quitte le caisson **1**, la plaque **28** dont l'aire est supérieure à celle de l'ouverture **15**, est retenue par le caisson **1** au niveau de cette ouverture sur une butée **27**. La plaque **28** est alors maintenue en contact avec le caisson **1** par le ressort **23** qui y est fixé de façon être encore suffisamment comprimé. Ainsi, la plaque **28** obstrue l'ouverture **15** dès que le ventilateur **3** a quitté le caisson **1**. Le débit d'air sortant **10** est égal au débit d'air entrant **11** en absence du ventilateur **3** dans le caisson **1** à tout moment.

Une introduction du ventilateur **3** dans le caisson **1** est effectué par processus inverse en remontant des figures 3c à 3a. La plaque **28** est alors initialement maintenue en contact avec le caisson par légère compression du ressort **23** comme représenté en figure 3c. L'introduction du ventilateur **3** vient pousser la plaque **28** qui subit un mouvement de rotation, comme représenté en figure 3b. La plaque **28** est maintenue en contact avec le ventilateur **3** au moyen du ressort **23** qui se comprime plus fortement. L'introduction du ventilateur **3** obstrue l'ouverture **15** de sorte que la valeur des débits **10** et **11** reste sensiblement constante. Le ventilateur **3** étant entièrement introduit dans le caisson **1** comme représenté en figure 3a, la plaque **28** est maintenue en contact avec le ventilateur **3**.

Grâce au dispositif représenté figures 3a à 3c, le bon refroidissement de l'équipement électronique **2** ne subit aucune interruption lors d'extraction ou d'introduction du ventilateur **3** par l'ouverture **15** dans le caisson **1**.

Selon une variante du dispositif de la figure **3**, il est possible de remplacer la butée **27** par un aimant de type de l'aimant **21** qui assure une obstruction parfaite de l'ouverture **15** par la plaque **28** en absence du ventilateur **3**.

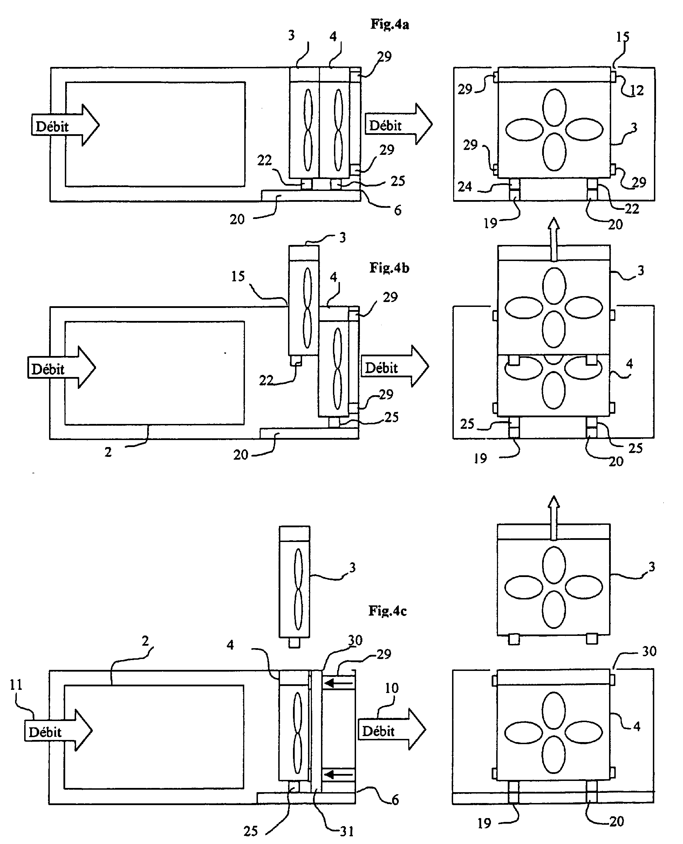

Dans l'exemple des figures 1 à 3, les ventilateurs **3, 4** sont montés en série. L'enseignement décrit reste valable pour des ventilateurs montés en parallèle et pour plus de deux ventilateurs. Les figures 4a à 4c présentent un exemple particulier de mise en oeuvre dans le cas où des ventilateurs **3, 4**, sont montés en série.

En référence à la figure 4a, le ventilateur **4**, le plus proche de la face extérieure **6**, est maintenu en contact avec le ventilateur **3**, au moyen de ressorts **29** fixés sur la paroi intérieure de la face **6**. Les ressorts **29** sont comprimés contre une face du ventilateur **4**, adjacente à la face **6**. Deux rails **19, 20**, raccordés à une alimentation non représentée, véhiculent une tension d'alimentation des ventilateurs **3, 4**. Le ventilateur **3** comprend un connecteur **22** enfiché sur le rail **20** et un connecteur **24** enfiché sur le rail **19**. De même, le ventilateur **4** comprend deux connecteurs **25**, enfichés chacun sur un rail **19, 20**.

En référence à la figure 4b, pendant l'extraction du ventilateur **3** par l'ouverture **15**, le ventilateur **4** est maintenu en contact avec le ventilateur **3** par la compression du ressort **29**. Les connecteurs **22, 24**, quittent les rails **19, 20**. Tant que la face inférieure du ventilateur **3** est dans le caisson **1**, le ventilateur **3** obstrue l'ouverture **15**, le ventilateur **4** est maintenu en position. Le refroidissement de l'équipement électronique **2** est identique à celui qui résulte de la figure 1b.

En référence à la figure 4c, lorsque la face inférieure du ventilateur **3** quitte le caisson **1**, le ventilateur **3** ne retient plus le ventilateur **4** poussé par les ressorts **29**. La décompression des ressorts **29** déplace le ventilateur **4** pour l'éloigner de la face **6**. Les connecteurs **25** du ventilateur **4** glissent sur les rails **19, 20** de façon à permettre la continuité de son alimentation. En prenant la place du ventilateur **3**, le ventilateur **4** obstrue l'ouverture **15** dès que le ventilateur **3** a quitté le caisson **1**. Le débit d'air sortant **10** est égal au débit d'air entrant **11** en absence du ventilateur **3** dans le caisson **1** à tout moment. Une ouverture **30** par laquelle avait été introduit le ventilateur **4**, reste béante. L'ouverture **30** n'est pas préjudiciable au bon refroidissement de l'équipement électronique **2** car le débit **10**, aspiré ou pulsé par le ventilateur **4**, est égal au débit **11**.

Une introduction du ventilateur **3** dans le caisson **1** est effectué par processus inverse en remontant des figures 4c à 4a. Le ventilateur **4** est alors initialement maintenue en contact avec l'intérieur du caisson par légère compression des ressorts **29** comme représenté en figure 4c. De façon avantageuse, les ressorts **29** n'appuient pas directement sur le ventilateur **4** mais sur une plaque **31** en contact avec la face externe du ventilateur **4**. La plaque **31** est prévue pour éviter tout bipasse sur les côtés du ventilateur **4**. La plaque **31** dépasse légèrement du caisson **1** par l'ouverture **29**. Ceci permet de faire glisser la plaque **31** vers la droite en comprimant les ressorts **29**. On admet à présent qu'un nouveau ventilateur **3** joue le rôle d'un nouveau ventilateur **4**, l'ancien ventilateur **4** ayant remplacé l'ancien ventilateur **3**. L'introduction du ventilateur **3** se fait à la place du ventilateur **4** tel que représenté en figure 4b. La plaque **31** est maintenue en contact avec le ventilateur **3** au moyen des ressorts **29** comprimés. L'introduction du ventilateur **3** obstrue l'ouverture **30** de sorte que la valeur des débits **10** et **11** reste sensiblement constante. Le nouveau ventilateur **3** étant entièrement introduit dans le caisson **1** comme représenté en figure 4a, la plaque **31** est maintenue en contact avec le ventilateur **3**.

Grâce au dispositif représenté figures 4a à 4c, le bon refroidissement de l'équipement électronique **2** ne subit aucune interruption lors d'extraction ou d'introduction du ventilateur **3** par l'ouverture **15** ou respectivement par l'ouverture **30** dans le caisson **1**.

L'introduction du nouveau ventilateur **3** dans le caisson enfiche ses connecteurs **22, 24** respectivement dans les rails **19, 20** pour permettre son alimentation électrique. Ce dispositif de connexion par rail est particulièrement utile pour le dispositif de la figure **4** car il permet une alimentation continue du ventilateur **4** pendant son déplacement en translation latérale dans le caisson **1**. Ce dispositif de connexion est utilisable sur les autres figures. Il n'y a pas été représenté car des dispositifs de connexion plus conventionnels conviennent également.

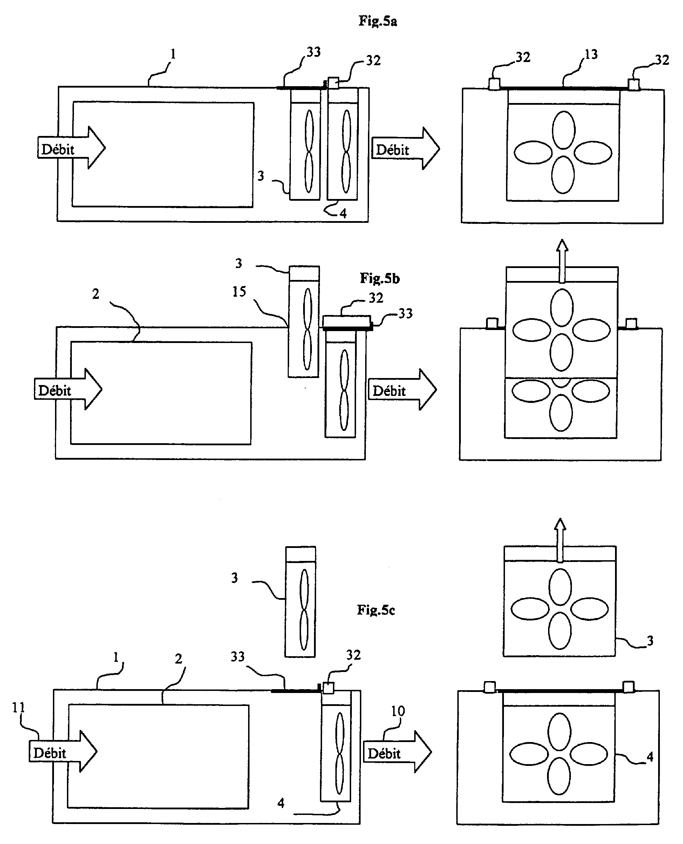

En référence aux figures 5a à 5c, une première extrémité de ressorts **32** est fixée sur une face extérieure du caisson **1** sur une arrête de l'ouverture **15**. Une première arrête de plaque **33** est fixée à une deuxième extrémité du ressort **32**. Les ressorts **32** sont tendus en élongation.

En référence à la figure 5a, la tension des ressorts **32** maintient la plaque **33** au dessus du ventilateur **3** de façon à fermer l'ouverture **15.** Le refroidissement par le dispositif de la figure 5a est identique à celui procuré par le dispositif de la figure 1a.

En référence à la figure 5b, la plaque **33** est ripée latéralement sur le caisson **1** de façon à dégager l'ouverture **15** pour extraire le ventilateur **3**. Le ripage de la plaque **33** provoque une surextension des ressorts **32** qui tend à ramener la plaque **33** dans sa position initiale au dessus de l'ouverture **15.** Pendant l'extraction du ventilateur **3** par l'ouverture **15**, la plaque **33** est maintenue en contact avec une face verticale du ventilateur **3** par la surextension des ressorts **32**. Cette surextension provoque une augmentation de contrainte des ressorts **32** qui maintient la plaque **33** contre le ventilateur **3**. Tant que la face verticale du ventilateur **3** est dans le caisson **1**, le ventilateur **3** obstrue l'ouverture **15**. Le refroidissement de l'équipement électronique **2** est identique à celui qui résulte de la figure 1b.

En référence à la figure 5c, lorsque la face verticale du ventilateur **3** quitte le caisson **1**, la plaque **33** est ramenée au dessus de l'ouverture **15**, par le ressort **32**. Ainsi, la plaque **33** obstrue l'ouverture **15** dès que le ventilateur **3** a quitté le caisson **1**. Le débit d'air sortant **10** est égal au débit d'air entrant **11** en absence du ventilateur **3** dans le caisson **1** à tout moment.

Une introduction du ventilateur **3** dans le caisson **1** est effectué par processus inverse en remontant des figures 5c à 5a. La plaque **33** est alors initialement maintenue au dessus de l'ouverture **15** par légère extension du ressort **32** comme représenté en figure 5c. La plaque **33** est ripée latéralement de façon à dégager l'ouverture **15**. L'introduction du ventilateur **3** maintient la plaque **33** en position ripée, comme représenté en figure 3b. La plaque **33** est maintenue en contact avec la face verticale du ventilateur **3** au moyen du ressort **32** qui reste tendu plus fortement. L'introduction du ventilateur **3** obstrue l'ouverture **15** de sorte que la valeur des débits **10** et **11** reste sensiblement constante. Le ventilateur **3** étant entièrement introduit dans le caisson **1** comme représenté en figure 5a, la plaque **33** est ramenée au dessus de l'ouverture **15** par le ressort **32**.

Grâce au dispositif représenté figures 5a à 5c, le bon refroidissement de l'équipement électronique **2** ne subit aucune interruption lors d'extraction ou d'introduction du ventilateur **3** par l'ouverture **15** dans le caisson **1**.

## Revendications

1. Caisson (1) comprenant au moins un équipement électronique (2) et une ouverture (15) pour extraire un premier ventilateur (3), un élément mobile (33) qui
- lorsque le ventilateur (3) est dans le caisson (1), est maintenu en contact avec au moins une face du ventilateur (3) et,
- lorsque le ventilateur (3) n'est pas dans le caisson (1), est maintenu en contact avec le caisson (1), de façon à obstruer l'ouverture (15) du caisson (1),
**caractérisé en ce que** ledit élément mobile est une plaque (33) maintenue en position d'obstruction de l'ouverture (15) par au moins un ressort (32), un ripage de ladite plaque (33) dégageant l'ouverture (15) de façon à permettre l'extraction du ventilateur (3) et à maintenir ladite plaque (33) contre le ventilateur (3) pendant l'extraction par augmentation de contrainte du ressort (32).

## Claims

1. A case (1) comprising at least one electronic equipment unit (2) and an opening (15) for extracting a first fan (3), a movable element (33) that
- when the fan (3) is inside the case (1), is maintained in contact with at least one side of the fan (3) and,
- when the fan is not inside the case (1), is maintained in contact with the case (1), so as to obstruct the opening (15) of the case (1),
**characterised in that** said movable element is a plate (33) maintained in a position of obstruction of the opening (15) by at least one spring (32), a movement of said plate (33) clearing the opening (15) so as to permit the extraction of the fan (3) and to maintain said plate (33) against the fan (3) during the extraction by increase in the stress of the spring (32).

## Patentansprüche

1. Kasten (1) mit mindestens einer elektronischen Vorrichtung (2) und einer Öffnung (15) zum Herausnehmen eines ersten Gebläses (3), einem beweglichen Element (33), das
- mit mindestens einer Fläche des Gebläses (3) in Kontakt gehalten ist, wenn das Gebläse (3) im Kasten (1) angeordnet ist, und
- mit dem Kasten (1) so in Kontakt gehalten ist, dass es die Öffnung (15) des Kastens (1) verschließt, wenn das Gebläse (3) nicht im Kasten (1) angeordnet ist,
**dadurch gekennzeichnet, dass** das bewegliche Element eine Platte (33) ist, die durch mindestens eine Feder (32) in der Stellung zum Verschließen der Öffnung (15) gehalten ist, wobei eine Verschiebung der Platte (33) die Öffnung (15) freigibt, so dass das Gebläse (3) herausgenommen werden kann und die Platte (33) beim Herausnehmen durch Erhöhung der Spannung der Feder (32) am Gebläse (3) gehalten ist.
